# EUROPEAN PATENT SPECIFICATION

(11) **EP 1 804 308 B1**
(45) Date of publication and mention of the grant of the patent: **04.04.2012**
(21) Application number: 06001230.9
(22) Date of filing: 20.01.2006
(51) Int. Cl.: H01L 51/52, H01L 51/50

(54) **An organic light emitting device with a plurality of organic electroluminescent units stacked upon each other**
Organische lichtemittierende Vorrichtung mit mehreren aufeinander gestapelten organischen elektrolumineszenten Einheiten
Dispositif organique émetteur de lumière ayant plusieurs unités électroluminescentes organiques empilées les unes sur les autres

(30) Priority: 23.12.2005 EP 05028297
(43) Date of publication of application: 04.07.2007
(73) Proprietor: Novaled AG, 01307 Dresden (DE)
(72) Inventor: Wellmann, Philipp, 64285 Darmstadt (DE); Werner, Ansgar, Dr., 01277 Dresden (DE); Murano, Sven, Dr., 01309 Dresden (DE); He, Gufeng, Dr., c/o Shanghai Jiao Tong University, 200240 Shanghai (CN)
(74) Representative: Bittner, Thomas L.

(56) References cited:
- EP-A- 1 339 112
- EP-A- 1 478 025

## Description

The invention relates to an organic light emitting device with a plurality of organic electroluminescent units stacked upon each other.

### Background of the invention

Organic electroluminescent (EL) devices are becoming of increasing interest for applications in the field of displays or lighting sources. Such organic light emitting devices or organic light emitting diodes (OLEDs) are electronic devices, which emit light if an electric potential is applied.

The structure of such OLEDs comprises, in sequence, an anode, an organic electroluminescent medium and a cathode. The electroluminescent medium, which is positioned between the anode and the cathode, is commonly comprised of an organic hole-transporting layer (HTL) and an electron-transporting layer (ETL). The light is then emitted near the interface between HTL and ETL where electrons and holes combine, forming excitons. Such a layer structure was used by Tang et al. in "Organic Electroluminescent Diodes", Applied Physics Letters, 51, 913 (1987), and commonly assigned US-A-4,769,292, demonstrating high efficient OLEDs for the first time.

Since then, multitudes of alternative organic layer structures have been disclosed. One example being three-layer OLEDs which contain an organic light emitting layer (EML) between the HTL and ETL, such as that disclosed by Adachi et al. in "Electroluminescence in Organic Films with Three-Layer Structure", Japanese Journal of Applied Physics, 27, L269 (1988), and by Tang et al. in "Electroluminescence of Doped Organic Thin Films", Journal of Applied Physics, 65, 3610 (1989). The EML may consist of a host material doped with a guest material, however neat light emitting layers may also be formed from a single material. Furthermore, the EML may contain two or more sublayers. The layer structure is then denoted as HTL / EML / ETL. Further developments show multilayer OLEDs which additionally contain a hole-injection layer (HIL), and / or an electron-injection layer (EIL), and / or a hole-blocking layer (HBL), and / or an electron-blocking layer (EBL), and or other types of interlayers between the EML and the HTL and / or ETL, respectively. These developments lead to further improvements in device performance, as the interlayers confine the excitons and the charge carriers within the emission zone and minimize quenching at the interface of the emissive region and the transport layers. They also might reduce the injection barrier from the transport layers into the emission zone, therefore leading to reduced operating voltages of the electroluminescent device.

A further improvement of the OLED performance can be achieved by the use of doped charge carrier transport layers as disclosed in EP 0 498 979 A1.

For this purpose, the ETL is doped with an electron donor such as an alkali metal, whereas the HTL is doped with an electron acceptor, such as F4-TCNQ. OLEDs using doped transport layers are commonly known as PIN-OLEDs. They feature extremely low operating voltages, often being close to the thermodynamical limit set by the wavelength of the emitted light.

In order to further improve the performance of OLEDs, such as for example the operation lifetime or the current efficiency, stacked or cascaded OLED structures have been proposed, in which several individual OLEDs arc vertically stacked. The improvement of the OLED performance in such stacked organic electroluminescent devices is generally attributed to an overall reduction of the operating current density combined with an increased operating voltage, as the individual OLEDs are connected in a row. Such a design leads to lower stress of the organic layers, since current injected and transported within the organic layers is reduced.

Additionally, the stacking of several OLED units in one device allows a mixing of different colors in one device, for example in order to generate white light emitting devices.

The realization of such stacked or cascaded organic electroluminescent devices can, for example be done by vertically stacking several OLEDs, which are each independently connected to a power source and which therefore are able to independently emit light of the same or of different color. This design was proposed to be used in full color displays or other emission devices with an increased integrated density (cf. US-A-5,703,436, US-A-6,274,980).

To avoid the need of connecting each of the individual OLEDs within the stacked devices, alternative designs were proposed, in which several OLEDs are vertically stacked without individually addressing each OLED in the unit stack. This was, for example, done by placing an intermediate conductive layer with an electrical resistance lower than 0.1Ωcm in between the individual OLEDs, consisting of materials such as metals, metal alloys or transparent conductive oxides (cf. US-A-6,107,734, US-A-6,337,492).

Alternatively, instead of using conductive intermediate layers, the usage of non-conductive charge generation layers was disclosed in the document US 2003 / 0189401 A1.

Furthermore, a layout using a connecting unit formed by an n-type doped organic layer and a p-type doped organic layer with a resistivity of each layer of more than 10Ωcm, in between the individual OLEDs was disclosed in the document EP 1 478 025 A2. This approach however requires two additional layers forming in each of the connecting units a p-n-junction to be laminated between the individual OLED units. In the simplest case, each of the single OLED units stacked by means of the connecting units is made of a two layer structure comprising a hole-transporting layer, and an electron-transporting layer.

The document EP 1 339 112 A2 discloses an organic electroluminescent device having stacked electroluminescent units. The stacked organic electroluminescent device comprises an anode, a cathode, a plurality of organic electroluminescent units disposed between the anode and the cathode, and a doped organic connectors disposed between each adjacent organic electroluminescent unit.

All the approaches mentioned above require the introduction of at least one additional layer in between the individual OLEDs forming the stacked organic electroluminescent device. Therefore, in prior art, additional process steps during fabrication of the devices are needed, leading to higher manufacturing costs and lower production yields. In many cases the additional intermediate layer or layers even consist of one or more materials which are neither used within the individual OLED units nor as cathode or anode of the device, which makes the introduction of one or more additional materials into the manufacturing process necessary. Furthermore, the introduction of additional layers into the layer architecture of the OLED device, such as metals or other interlayers, might lead to additional light losses due to absorption.

In addition, it is commonly accepted that stacking of OLED devices can only be achieved without significant loss in device efficiency, if an adequate intermediate layer is introduced in between the individual OLEDs of the stacked unit. Therefore the significant drawbacks of such intermediate layers are accepted as a necessity.

### The invention

It is the object of the present invention, to provide an improved light emitting device with a plurality of stacked organic electroluminescent units which can be fabricated by a simplified production process. In addition, production costs shall be reduced.

This object is solved by a light emitting device with a plurality of stacked organic electroluminescent units according to claim 1. Advantageous developments of the invention are disclosed in dependent claims.

In contrast to the prior art, there is no interlayer provided in between adjacent organic electroluminescent units. It was found that such interlayers can be omitted if in the stack of the individual organic electroluminescent units, which are also referred to as individual OLED units, the single n-type doped ETL is brought in direct contact with the single p-type doped HTL of the adjacent OLED unit, directly forming a p-n-junction at the interface between the adjacent OLED units.

The invention enables fabrication of stacked organic light emitting devices where the introduction of any kind of intermediate layer in between the individual OLEDs can be omitted. This will allow for a cheaper production of stacked OLED devices as no additional material deposition steps need to be introduced into the production process, reducing the overall numbers of layers within the device as well as possibly also the number of materials used within the device.

In a preferred embodiment, the fixation in the p-type doped HTL is ensured by a high molecular weight of the p-dopant (> 300 g / mol) preventing it from a migration into the n-type doped ETL. In the case of the n-type doped ETL, in a preferred embodiment, the fixation of the n-dopant is ensured by the formation of a complex between the matrix material, e.g. BPhen or a similar material and the dopant, e.g. Cs or any other alkali metal or alternatively by using an n-dopant with a high molecular weight (> 300 g / mol). However, both mentioned principles are generally applicable for both the HTL and the ETL.

In preferred embodiments of the invention the stacked organic electroluminescent units comprise at least one of the following layers: an hole-injection layer (HIL), an electron-injection layer (EIL), an interlayer in between said p-type doped hole-transporting layer and said electroluminescent zone, and a further interlayer between said n-type doped electron-transporting layer and said electroluminescent zone.

In a simple case the electroluminescent unit would be denoted p-HTL / EML / n-ETL. The electroluminescent units, however, may also consist of multilayer structures that are well known in the art, such as p-HTL / EBL or HIL / EML / n-ETL, or p-HTL / EML / HBL or EIL / n-ETL or any other multilayer architecture which allows to have, as described above, the n-ETL and the p-HTL of adjacent electroluminescent units in direct contact in the stack.

There are many organic multilayer structures for the EML known in the art which can be used as the light emitting layer within the organic electroluminescent units of the organic light emitting device. The layer structure within the light emitting zone might consist of one or more consecutive layers containing one or more organic host materials and one or more fluorescent or phosphorescent electroluminescent emitter materials. Nevertheless, one or more of the layers of the EML may not contain fluorescent or phosphorescent electroluminescent emitter materials. The EML may be formed from small organic molecules, i.e. molecules that are small enough to be vacuum deposited, e.g. by sublimation or evaporation, or from organic polymers. Different EMLs within the organic electroluminescent units of the organic light emitting device may be made of different materials.

In a preferred embodiment of the organic light emitting device, for at least one of said organic electroluminescent units the p-type doped hole transporting-layer (HTL) and the n-type doped electron-transporting layer (ETL) are made of a matrix material which is the same material for the p-type doped hole transporting-layer (HTL) and the n-type doped electron-transporting layer (ETL), where for p-type doped hole transporting-layer (HTL) the matrix material is p-doped, and for the n-type doped electron-transporting layer (ETL) the matrix material is n-doped. Matrix materials which can be used are known as such, for example from Harada et al. (Phys. Rev. Lett. 94, 036601 (2005)).

### Description of preferred embodiments of the invention

In the following the invention will be described in further detail, by way of example, with reference to different embodiments. In the figures:
- Fig. 1: is a schematic cross sectional view of a light emitting device with a plurality of stacked organic electroluminescent units;
- Fig. 2: is a schematic cross sectional view of an individual organic electroluminescent unit; and
- Fig. 3: is a diagram showing the power efficiency versus luminance of a light emitting device in accordance with the invention and a reference device.

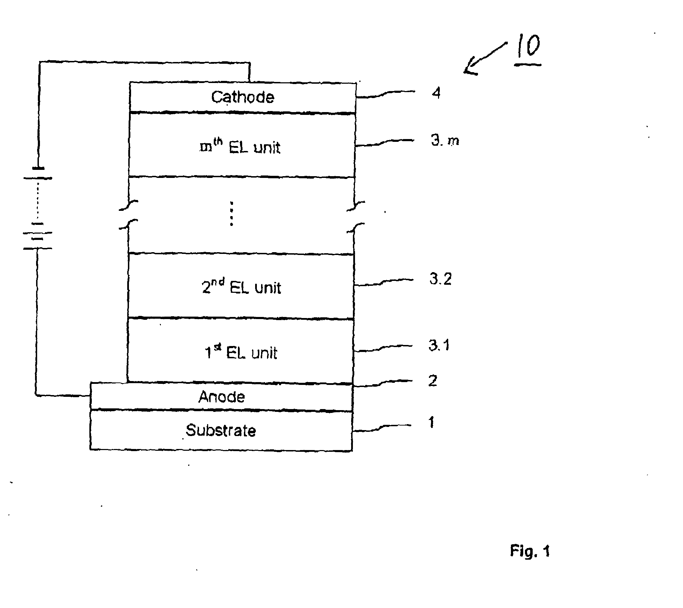

Referring to Fig. 1, an organic light emitting device 10 with a plurality of stacked organic electroluminescent units comprises an anode 2 which is provided on a substrate 1, a cathode 4, and a number of m (m ≥ 2) organic electroluminescent units (EL units) 3.1, ..., 3.m which are also referred to as OLED units. The organic electroluminescent units 3.1, ..., 3.m are directly stacked upon each other, forming a cascade / stack of organic electroluminescent units.

In an alternative embodiment (not shown) the cathode is provided on a substrate, and the anode is provided as a top electrode.

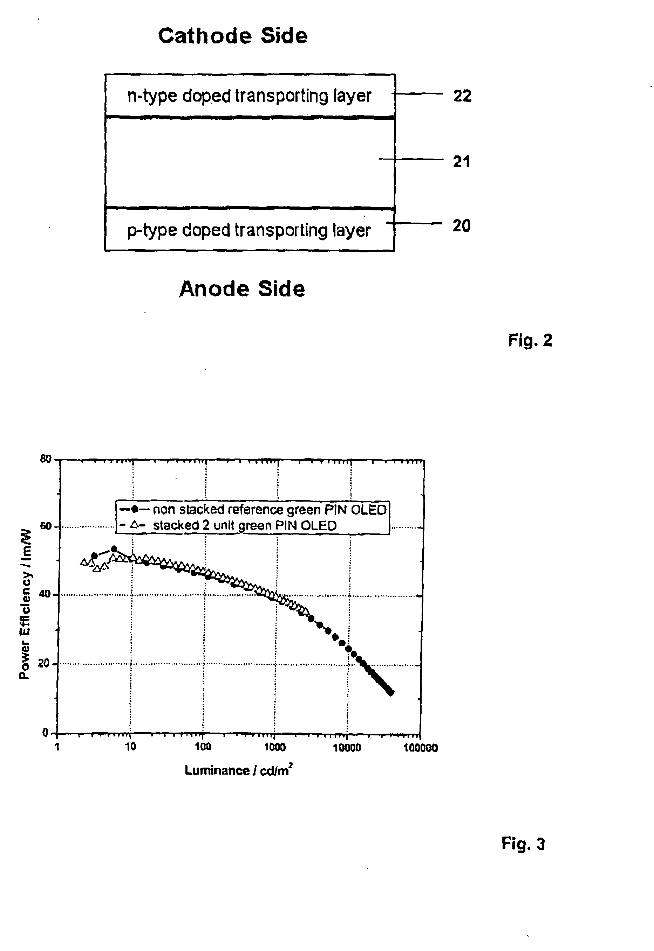

Fig. 2 is a schematic cross sectional view of an individual organic electroluminescent unit. Each individual electroluminescent unit / OLED unit comprises at least a p-type doped hole-transporting layer (HTL) 20, an electroluminescent layer or zone (EML) 21, and an n-type doped electron-transporting layer (ETL) 22. The n-type doped electron-transporting layer 22 consists of an organic main material doped with a donor-type substance, and the p-type doped hole-transporting layer 20 consists of an organic main material doped with an acceptor-type substance. Preferably the dopant substance is a high molecular weight material (> 300 g /mol), and / or in the case of n-type doping an alkali metal.

In case of Cs or alkali metal doping or doping by alkali metal compounds the doping ratio shall be as low that all Cs or alkali metal molecules form a complex with the matrix molecules, preferentially below 1:3 (Cs to matrix) in molecular ratio. In case of n-doping by a dopant molecule with M > 300 g / mol the gas phase ionization potential of the dopant shall be < 4,0 eV, more preferentially < 3,8 eV.

The OLED units might furthermore comprise additional hole-injection layer(s) (HIL) and / or electron injection layer(s) (EIL) and / or hole-blocking layer(s) (HBL) and / or electron-blocking layer(s) (EBL) and / or other type(s) of interlayers between the EML and the HTL and / or the ETL. Those interlayers may act as a suppression of exciplex formation at the interface of transport layers and emission zone or as confinement for the excitons generated. Preferentially they exhibit a higher hole or, respectively, electron mobility and electron or, respectively, hole blocking behaviour. The thickness of these interlayers is typically in the range of about 1 to 20 nm.

There are many organic multilayer structures for the EML known in the art which can be used as the light emitting layer within, the electroluminescent units of the organic light emitting device according to the invention. The layer structure within the electroluminescent units might consist of one or more consecutive layers containing one or more organic host materials and one or more fluorescent or phosphorescent electroluminescent emitter materials. The EML may be formed from small organic molecules or from organic polymers. Different EMLs within the EL units of the organic light emitting device 10 may be made of different materials.

An embodiment of the invention is given as follows, which shows the common case of the multi units cascaded device. The organic light emitting device 10 with m (m ≥ 2) EL units consists of:
1. substrate 1,
2. bottom electrode 2, e.g. hole injecting anode,
3.1. 1^{st} EL unit,
3.2. 2^{nd} EL unit,
3.m. m^{th} EL unit,
4. top electrode 4, e.g. electron injecting cathode,
where each electroluminescent unit comprises at least the following layers: a p-type doped hole-transporting layer (HTL) close to the bottom electrode (anode 2 in Fig. 1), an n-type doped electron-transporting layer (ETL) close to the top electrode (cathode 4 in Fig. 1) and an electroluminescent layer (EML) in between (cf. Fig. 2).

In general, regardless of the position of the cathode and the anode in the stack, in each of the electroluminescent units the p-type doped hole-transporting layer is close to the anode, and the n-type doped electron-transporting layer is close to the cathode. The n-type doped electron-transporting layer of the k^{th} electroluminescent unit (1 ≤ k < m) is directly connected with the p-type doped hole-transporting layer of the (k+1)^{th} electroluminescent unit without any intermediate layer. Within the electroluminescent units one or more additional layers such as an electron or a hole blocking layer (EBL, HBL) or interlayers may be employed between the p-type doped hole-transporting layer (HTL) and the n-type doped electron-transporting layer (ETL) to improve efficiency.

The following examples are presented for a further understanding of the invention. The materials arc example materials which demonstrate the layer setup.

The organic layers and metal arc deposited by thermal evaporation onto patterned and precleaned indium tin oxide (ITO) coated glass substrates in an ultrahigh vacuum system at 10⁻⁷ mbar base pressure without breaking vacuum. The deposition rate and the thickness of the deposited layer are controlled by using a thickness monitor.

### Example 1 (Reference)

1) 45nm 2,2',7,7'-Tetrakis-(N,N-di-methylphenylamino)-9,9'-spirobifluoren doped with 2-(6-Dicyanomethylene-1,3,4,5,7,8-hexafluoro-6*H*-naphtalen-2-ylidene)-malononitrile (p-HTL);
2) 20nm 4,4',4"-tris(N-carbazolyl)-triphenylamine doped with fac-tris(2-phenylpyridine) iridium;
3) 10nm 1,3,5-tri(phenyl-2-benzimidazole)-benzene doped with fac-tris(2-phenylpyridine) iridium;
4) 40nm Bathophenantroline doped with Cs (n-ETL); and
5) 100nm Aluminum as a reflective cathode.

The EML is made of layers 2), and 3). This is a green phosphorescent PIN OLED having color coordinates of 0,29/0,64 at a brightness of 1000 cd/m². This brightness is reached at an operating voltage of 4,15 V, much lower than those without p-type doped hole-transporting layers and n-type doped electron-transporting layers. At a brightness of 1000 cd/m² the current efficiency of the device is 51,3 cd/A. The power efficiency at this brightness is 38,8 lm/W.

### Example 2 (stacked electroluminescent units)

1) 45nm 2,2',7,7'-Tetrakis-(N,N-di-methylphenylamino)-9,9'-spirobifluoren doped with 2-(6-Dicyanomethylene-1,3,4,5,7,8-hexafluoro-6H-naphtalen-2-ylidene)-malononitrile (p-HTL);
2) 20nm 4,4',4"-tris(N-carbazolyl)-triphenylamine doped with fac-tris(2-phenylpyridine) iridium;
3) 10nm 1,3,5-tri(phenyl-2-benzimidazole)-benzene doped with fac-tris(2-phenylpyridine) iridium;
4) 40nm Bathophenantroline doped with Cs (n-ETL);

### (1^{st} electroluminescent unit)

5) 95nm 2,2',7,7'-Tetrakis-(N,N-di-methylphenylamino)-9,9'-spirobifluoren doped with 2-(6-Dicyanomethylene-1,3,4,5,7,8-hexafluoro-6*H*-naphtalen-2-ylidene)-malononitrile (p-HTL);
6) 20nm 4,4',4"-tris(N-carbazolyl)-triphenylamine doped with fac-tris(2-phenylpyridine) iridium;
7) 10nm 1,3,5-tri(phenyl-2-benzimidazole)-benzene doped with fac-tris(2-phenylpyridine) indium;
8) 40nm Bathophenantroline doped with Cs (n-ETL); (2^{nd} electroluminescent unit)
9) 100nm Aluminium as a reflective cathode.

The EML is provided by the layers 2), 3) and 6), 7), respectively. This is a stacked green phosphorescent PIN OLED consisting of two PIN OLED units and having color coordinates of 0,32/0,63 at a brightness of 1000 cd/m². This brightness is reached at an operating voltage of 9,2 V. The current efficiency of the device at a brightness of 1000 cd/m² is 116,6 cd/A, the power efficiency at this brightness is 39,7 Im/W.

The operating voltage of the stacked green PIN OLED is more than twice as high as for the non stacked reference device, however the current efficiency is also increased by more than a factor of two. The power efficiency versus luminance plot in figure 3 shows, that both the non stacked green PIN reference OLED device and the stacked green PIN OLED reach similar power efficiencies at the same luminance levels.

It has been demonstrated, that by directly stacking two PIN OLED units the same power efficiencies for cascaded OLED devices can be achieved as for non-stacked devices. No additional layer between the stacked OLED units as it was considered to be necessary in the prior art is used.

## Claims

1. An organic light emitting device comprising:
- an anode (2);
- a cathode (4); and
- a plurality of organic electroluminescent units (3.1, ..., 3.m; m = 2, 3, ...) provided upon each other in a stack or an inverted stack between said anode (2) and said cathode (4) each of the organic electroluminescent units (3.1, ..., 3.m) comprising two doped transporting-layers, namely a p-type doped hole-transporting layer (p-HTL) and a n-type doped electron-transporting layer (n-ETL), and an electroluminescent zone (EML) formed between the p-HTL and the n-ETL;
wherein:
- for the first organic electroluminescent unit (3.1), the p-HTL is in direct contact with the anode (2);
- for the m^{th} organic electroluminescent unit (3.m), the n-ETL is in direct contact with the cathode (4);
- for all of said organic electroluminescent units (3.1, ..., 3.m), within the stack or the inverted stack adjacent doped transporting layers provided in two adjacent organic electroluminescent units and adjacent to each other are in direct contact, thereby forming a p-n-junction between an adjacent p-HTL provided in one of the two adjacent organic electroluminescent units and an adjacent n-ETL provided in the other one of the two adjacent organic electroluminescent units; and
- for all of said organic electroluminescent units (3.1, ..., 3.m), the organic electroluminescent unit is provided as a unit selected from the following group of units:
- p-HTL / EML / n-ETL,
- p-HTL / EBL / EML / n-ETL,
- p-HTL l HIL / EML / n-ETL,
- p-HTL / EML / HBL / n-ETL,
- p-HTL / EML / EIL / n-ETL, and
- p-HTL l EBL / EML / HBL / n-ETL,
where HIL is a hole injection layer, EIL is an electron injection layer, HBL is a hole blocking layer, and EBL is an electron blocking layer.

2. Organic light emitting device according to claim 1, wherein for at least one of said organic electroluminescent units (3.1, ..., 3.m) the electroluminescent zone is formed by a multilayer structure of organic layers.

3. Organic light emitting device according to one of the preceding claims, wherein for at least one of said organic electroluminescent units (3.1, ..., 3.m) the p-HTL is doped with an acceptor dopant having a high molecular weight, namely a weight of more than about 300 g / mol.

4. Organic light emitting device according to one of the preceding claims, wherein for at least one of said organic electroluminescent units (3.1, ..., 3.m) the n-ETL is doped with a donator dopant having a high molecular weight, namely a weight of more than about 300 g / mol.

5. Organic light emitting device according to one of the preceding claims, wherein for at least one of said organic electroluminescent units (3.1, ..., 3.m) the n-ETL is doped with an alkali metal or an alkali metal compound with a molar ratio of < 1:3 of the alkali metal or the alkali metal compound in respect to a matrix material.

6. Organic light emitting device according to one of the preceding claims, wherein for at least one of said organic electroluminescent units (3.1, ..., 3.m) the electroluminescent zone is formed from a material of small molecules and / or from organic polymers.

7. Organic light emitting device according to one of the preceding claims, wherein for at least one of said organic electroluminescent units (3.1, ..., 3.m) the p-HTL and the n-ETL are made of a matrix material which is the same material for the p-HTL and the n-ETL, where for the p-HTL the matrix material is p-doped, and for the n-ETL the matrix material is n-doped.

## Patentansprüche

1. Organische lichtemittierende Vorrichtung, mit:
- einer Anode (2),
- einer Kathode (4) und
- mehreren organischen elektrolumineszierenden Einheiten (3.1, ..., 3.m; m = 2, 3, ...), die als ein Stapel oder ein invertierter Stapel zwischen der Anode (2) und der Kathode (4) aufeinander angeordnet sind, wobei jede der organischen elektrolumineszierenden Einheiten (3.1, ..., 3.m) mit zwei dotierten Transportschichten, nämlich einer p-dotierten Löchertransportschicht (p-HTL) und einer n-dotierten Elektronentransportschicht (n-ETL) und einem elektrolumineszierenden Bereich (EML), der zwischen der p-HTL und der n-ETL angeordnet ist, gebildet ist,
wobei:
- in der ersten elektrolumineszierenden Einheit (3.1) die p-HTL in direktem Kontakt mit der Anode (2) gebildet ist,
- in der m-ten organischen elektrolumineszierenden Einheit (3.m) die n-ETL in direktem Kontakt mit der Kathode (4) gebildet ist,
- in den organischen elektrolumineszierenden Einheiten (3.1, ..., 3.m) innerhalb des Stapels oder des invertierten Stapels, die angrenzenden dotierten Transportschichten zweier benachbarter organischer elektrolumineszierender Einheiten derart ausgebildet sind, dass sie in direktem Kontakt zueinander sind, sodass ein p-n-Übergang zwischen einer p-HTL in einer der zwei benachbarten organischen elektrolumineszierenden Einheiten und einer benachbarten n-ETL in einer anderen der zwei benachbarten organischen elektrolumineszierenden Einheiten gebildet ist, und
- die organischen elektrolumineszierenden Einheiten (3.1, ..., 3.m) jeweils eine Einheit ausgewählt aus der folgenden Gruppe von organischen elektrolumineszierenden Einheiten sind:
- p-HTL / EML / n-ETL,
- p-HTL / EBL / EML / n-ETL,
- p-HTL / HIL / EML / n-ETL,
- p-HTL / EML / HBL / n-ETL,
- p-HTL / EML / EIL / n-ETL, und
- p-HTL / EBL / EML / HBL / n-ETL,
wobei HIL eine Löcherinjektionsschicht, EIL eine Elektroninjektionsschicht, HBL eine Löcherblockierungsschicht und EBL eine Elektronenblockierungsschicht ist.

2. Organische lichtemittierende Vorrichtung nach Anspruch 1, wobei in wenigstens einer der elektrolumineszierenden Einheiten (3.1, ..., 3.m) der elektrolumineszierenden Bereich aus einer Multilayer-Struktur mit organischen Schichten gebildet ist.

3. Organische lichtemittierende Vorrichtung nach einem der vorhergehenden Ansprüche, wobei in wenigstens einer der organischen elektrolumineszierenden Einheiten (3.1, ..., 3.m) die p-HTL mit einem Akzeptor-Dotanden dotiert ist, welcher ein hohes molekulares Gewicht aufweist, nämlich ein Gewicht von mehr als 300 g / mol.

4. Organische lichtemittierende Vorrichtung nach einem der vorhergehenden Ansprüche, wobei in wenigstens einer der organischen elektrolumineszierenden Einheiten (3.1, ..., 3.m) die n-ETL mit einem Donator-Dotanden dotiert ist, welcher ein hohes molekulares Gewicht aufweist, nämlich ein Gewicht von mehr als 300 g / mol.

5. Organische lichtemittierende Vorrichtung nach einem der vorhergehenden Ansprüche, wobei in wenigstens einer der organischen elektrolumineszierenden Einheiten (3.1, ..., 3.m) die n-ETL mit einem Alkalimetall oder einer Alkalimetallverbindung mit einem molaren Verhältnis größer als 1:3 aus Alkalimetall oder Alkalimetallverbindungen zu einem Matrixmaterial dotiert ist.

6. Organische lichtemittierende Vorrichtung nach einem der vorhergehenden Ansprüche, wobei in wenigstens einer der organischen elektrolumineszierenden Einheiten (3.1, ..., 3.m) der elektrolumineszierende Bereich mit einem Material aus niedermolekularen Verbindungen und / oder aus organischen Polymeren gebildet ist.

7. Organische lichtemittierende Vorrichtung nach einem der vorhergehenden Ansprüche, wobei in wenigstens einer der organischen elektrolumineszierenden Einheiten (3.1, ..., 3.m) die p-HTL und die n-ETL mit einem Matrixmaterial gebildet sind, welches dasselbe Matrixmaterial für die p-HTL und die n-ETL ist, wobei das Matrixmaterial für die p-HTL p-dotiert und für die n-ETL n-dotiert ist.

## Revendications

1. Dispositif émetteur de lumière organique comprenant :
- une anode (2) ;
- une cathode (4) ; et
- une pluralité d'unités électroluminescentes organiques (3.1, ..., 3.m ; m = 2, 3, ...) disposées l'une sur l'autre dans une pile ou dans une pile inversée entre ladite anode (2) et ladite cathode (4), chacune des unités électroluminescentes organiques (3.1, ..., 3.m) comprenant deux couches de transport dopées, en l'occurrence une couche de transport de trous dopée de type p (p-HTL) et une couche de transport d'électrons dopée de type n (n-ETL), et une zone électroluminescente (EML) formée entre la p-HTL et la n-ETL ;
dans lequel :
- pour la première unité électroluminescente organique (3.1), la p-HTL est en contact direct avec l'anode (2) ;
- pour la m^{ème} unité électroluminescente organique (3.m), la n-ETL est en contact direct avec la cathode (4) ;
- pour toutes lesdites unités électroluminescentes organiques (3.1, ..., 3.m), à l'intérieur de la pile ou de la pile inversée, les couches de transport dopées adjacentes disposées dans les deux unités électroluminescentes organiques adjacentes et adjacentes l'une à l'autre sont en contact direct, en formant de ce fait une jonction p-n entre une p-HTL adjacente disposée dans l'une des deux unités électroluminescentes organiques adjacentes et une n-ETL adjacente disposée dans l'autre des deux unités électroluminescentes organiques adjacentes ; et
- pour toutes lesdites unités électroluminescentes organiques (3.1, ..., 3.m), l'unité électroluminescente organique est fournie en tant qu'unité sélectionnée dans le groupe suivant d'unités :
- p-HTL / EML / n-ETL,
- p-HTL / EBL / EML / n-ETL,
- p-HTL / HIL / EML / n-ETL,
- p-HTL / EML / HBL / n-ETL,
- p-HTL / EML / EIL / n-ETL, et
- p-HTL / EBL / EML / HBL / n-ETL,
où HIL est une couche d'injection de trous, EIL est une couche d'injection d'électrons, HBL est une couche de blocage de trous, et EBL est une couche de blocage d'électrons.

2. Dispositif émetteur de lumière organique selon la revendication 1, dans lequel pour au moins l'une desdites unités électroluminescentes organiques (3.1, ..., 3.m), la zone électroluminescente est formée par une structure multicouche de couches organiques.

3. Dispositif émetteur de lumière organique selon l'une quelconque des revendications précédentes, dans lequel pour au moins l'une desdites unités électroluminescentes organiques (3.1, ..., 3.m), la p-HTL est dopée avec un dopant accepteur ayant un poids moléculaire élevé, en l'occurrence un poids supérieur à environ 300 g/mol.

4. Dispositif émetteur de lumière organique selon l'une quelconque des revendications précédentes, dans lequel pour au moins l'une desdites unités électroluminescentes organiques (3.1, ..., 3.m), la n-ETL est dopée avec un dopant donneur ayant un poids moléculaire élevé, en l'occurrence un poids supérieur à environ 300 g/mol.

5. Dispositif émetteur de lumière organique selon l'une quelconque des revendications précédentes, dans lequel pour au moins l'une desdites unités électroluminescentes organiques (3.1, ..., 3.m), la n-ETL est dopée avec un métal alcalin ou un composé de métal alcalin ayant un rapport molaire inférieur à 1:3 du métal alcalin ou du composé de métal alcalin sur un matériau de matrice.

6. Dispositif émetteur de lumière organique selon l'une quelconque des revendications précédentes, dans lequel pour au moins l'une desdites unités électroluminescentes organiques (3.1, ..., 3.m), la zone électroluminescente est constituée d'un matériau de petites molécules et/ou de polymères organiques.

7. Dispositif émetteur de lumière organique selon l'une quelconque des revendications précédentes, dans lequel pour au moins l'une desdites unités électroluminescentes organiques (3.1, ..., 3.m), la p-HTL et la n-ETL sont constituées d'un matériau de matrice qui est le même matériau pour la p-HTL et la n-ETL, où pour la p-HTL le matériau de matrice est dopé p, et pour la n-ETL le matériau de matrice est dopé n.
